# EUROPEAN PATENT SPECIFICATION

(11) **EP 3 166 122 B1**
(45) Date of publication and mention of the grant of the patent: **16.03.2022**
(21) Application number: 16179648.7
(22) Date of filing: 15.07.2016
(51) Int. Cl.: H01H 13/06, H01H 36/00, H03K 17/97, H01H 13/02

(54) **MAGNETIC PUSH-BUTTON SWITCH**
MAGNETISCHER DRUCKKNOPFSCHALTER
INTERRUPTEUR À POUSSOIR MAGNÉTIQUE

(30) Priority: 06.11.2015 TR 201513946 U
(43) Date of publication of application: 10.05.2017
(73) Proprietor: MAKERSAN MAKINA OTOMOTIV SANAYI TICARET ANONIM SIRKETI, Gebze / Kocaeli (TR)
(72) Inventor: ERKOCAK, Levent, 41490 Kocaeli (TR); ATAY, Asli, 41490 Kocaeli (TR)
(74) Representative: Sevinç, Erkan

(56) References cited:
- DE-A1-102006 051 023
- DE-U1- 20 116 512
- US-A- 5 714 728
- US-A1- 2010 007 402
- US-A1- 2010 102 907

## Description

### Technical Field of the Invention

The present invention relates to a button, and more specifically a magnetic push-button switch with improved strength which operates in a non-contact manner.

### State of the Art

Push-button switches are two-position devices actuated with a button that is pressed and released. In the prior art, there are mainly two types of plastics push-button switches, one of these types provides contacting and comprises a hole which can reach up to a printed circuit board placed therein. Other type push-button switches can be given as magnetic push-button switches with a non-contact feature. In this type of switches, a spring or a resilient member is present therebetween, and non-contact connection thereof with the printed circuit board is provided.

One of the common problems encountered in switches having a contacting feature present in the state of the art is sealing problem. Non-contacting feature of the switches to be used under harsh operating conditions is preferred in terms of sealing. On the other hand, in the switches used in a non-contact manner, use of a resilient member is placed into the body, wherein sealing cannot be provided sufficiently in case of a potential tearing or breaking of this resilient member.

US 2010/102907 A1 relates to a compact wireless sensors with plunger switches, and, particularly for the insertion of these type sensors within door frames as a means for detecting intrusion. A frame of the switch which includes the spring housing and the middle frame, are fastened together during assembly (e.g., glued or sonic welded) to keep the plunger, magnet, and spring from being removed from the frame. The document discloses that a moisture barrier, such as a plastic wall, may be used to isolate the plunger switch and magnet elements from the electronic portions of the wireless sensor.

Push-button switches used in the industry and especially in off-road devices can be exposed to very harsh environmental conditions and by protecting its sealing long-lasting operation thereof is desired even under these harsh conditions. Accordingly, there is a need for a switch by which sealing is provided and thus which is long lasting.

### Objects of the Invention

The main object of the present invention is to provide a switch in which sealing problem is completely eliminated by means of an intermediate layer.

Another object of the invention is to provide a long-lasting push-button switch such that said switch will maintain sealing even in case the button inside the switch is broken down.

Another object of the invention is to provide a push-button switch with reduced cost by eliminating the use of spring as a resilient member for sealing.

### Summary of the Invention

The present invention proposes a push-button switch comprising: a body; a button at least partially placed into the body; a magnetic member attached with the button; a resilient member placed between the button and the body; and a printed circuit board positioned in the body wherein the body comprises a cylindrically formed inner housing and an intermediate portion integrated with an inner portion of the body forming a closed intermediate layer inside the body closing the bottom of said cylindrically formed inner housing such that a longitudinal cross section of the push-button switch is in a H type so as to prevent leakage to the printed circuit board therein, wherein the printed circuit board is positioned under the intermediate portion and the magnetic member is positioned above the intermediate portion. Moreover, said switch further comprises at least one recess on said body and at least one claw on the button in a manner to correspond to this at least one recess.

### Brief Description of the Figures

Accompanying drawings are given solely for the purpose of exemplifying a push-button switch whose advantages over prior art were outlined above and will be explained in detail hereinafter:
Fig. 1 demonstrates an exploded view of the switch according to the present invention.

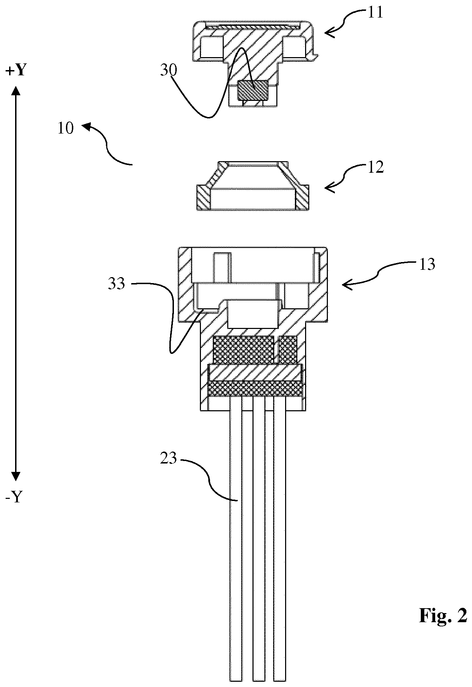

Fig. 2 demonstrates a cross sectional view of the switch shown in figure 1.
Fig. 3 demonstrates a cross sectional view of the switch taken along longitudinal axis, according to the present invention.
Fig. 4 demonstrates a cross sectional view of the body of the switch according to the present invention.

### Detailed Description of the Invention

The invention, based on the figures given in the attachment of the description, will be described in a detailed manner in this section, wherein the reference list used in the figures is as follows;
- 10.: Push-button switch
- 11.: Button
- 12.: Resilient member
- 13.: Body
- 14.: Connection ring
- 15.: Printed circuit board
- 20.: Threaded portion
- 21.: Claw
- 22.: Recess
- 23.: Cable
- 30.: Magnetic member
- 32.: Inner housing
- 33.: Air vent recess
- 35.: Support protrusion
- 40.: Intermediate portion
- 40a.: Intermediate portion upper section
- 40b.: Intermediate portion lower section
- 42.: Magnetic member housing
- 44.: Connection ring threaded portion

Referring now to the figures outlined above, a push-button switch (10) mainly comprises a body (13) having an intermediate portion (40) with an integrated intermediate layer in the middle thereof; a button (11) suitable for positioning inside this body (13); at least one recess (22) for engaging with at least one claw (21) disposed on the button (11); a printed circuit board (15) in a manner to remain under the intermediate portion (40) and suitable connection cables (23).

Said push-button switch (10) presented in the preferred embodiment of the invention is fitted with suitable claw and recesses which move up and down according to the longitudinal axis of the body (13) in which it is positioned. The button (11) brings the switch (10) to "on" or "off" position by the user pushing thereon is preferably formed cylindrically, and it comprises at least one claw (21) extending outward over the outer wall. Said claws (21) correspond to the opposing recesses disposed preferably close to the upper portion of the body (13). Hollow cylindrical resilient member (12) positioned in a manner to remain between the button (11) and the intermediate portion (40) inside the body (13) creates pressure on the button (11) and provides the button (11) to remain in the desired manner according to the state of use.

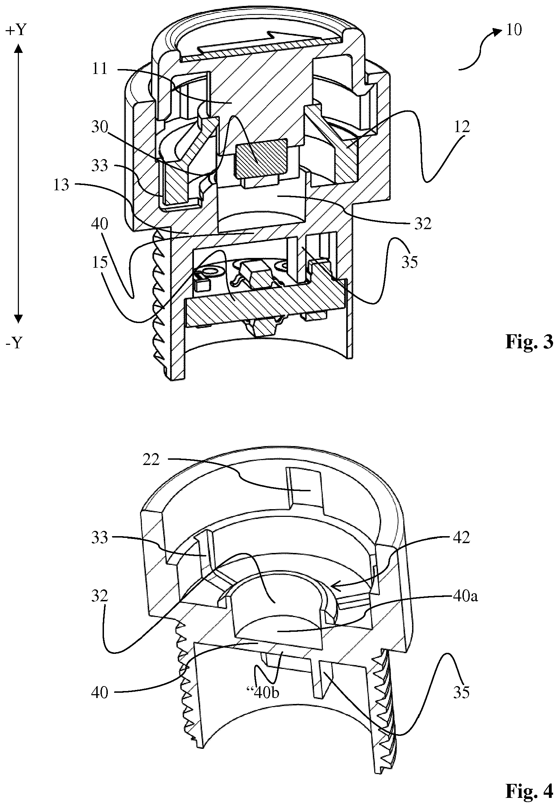

Referring to Figure 3, a magnetic member (30), disposed in magnetic member housing (42) of said button (11) in an integrated manner, is placed nearby to the button (11) surface facing the intermediate portion (40) and magnetic interaction thereof is provided as it approaches to the printed circuit board (15) placed under the intermediate portion (40). The printed circuit board (15) positioned in a manner to remain under the intermediate portion (40) can be kept in the desired distance with a support protrusion (35) in the lower section of the body. A volume of the place to where the PCB (15) is placed filled with epoxy material for enhancing impermeability. Thus, a more durable button structure, in which printed circuit board is protected, is obtained.

Said magnetic member (30) can either be of the substances which are naturally magnetized in nature or be artificially prepared alloys such as NdFeB, Sm-Co, Sm-Fe, samarium, cobalt, and neodymium. While magnetic member (30) can be provided in an embedded manner preferably inside the button (11), it can also be used by being attached to one end of the button (11). In regard to obtaining a push-button switch providing accurate sealing which is suitable for operating in industrial machines operating under harsh conditions or off-road vehicles, it is provided with a switch having an "H" type cross section. Thus, unwanted conditions such as leakage occurring due to the fact that another resilient member incorporated loses its function in time are eliminated.

As can be seen in Figure 3, said body (13) comprises a cylindrically formed inner housing (32) the bottom of which is closed with intermediate portion (40). Upon pushing said button (11), lower section of the button (11) comprising magnetic member is embedded in the inner housing (32). The button (11), upon being pushed by the user, enters into interaction by approaching to the intermediate portion (40) and printed circuit board (15). After the user withdraws the force s/he applies on the button (11), the button (11) assumes its former position by automatically moving upward (+Y) by means of resilient member (12). Resilient member (12) is a spring-like member, the shape of which can change when a force acts thereon and which can assume its former state after the force is withdrawn, wherein it provides the button (11) to assume its former position by withdrawing the force applied on the button (11).

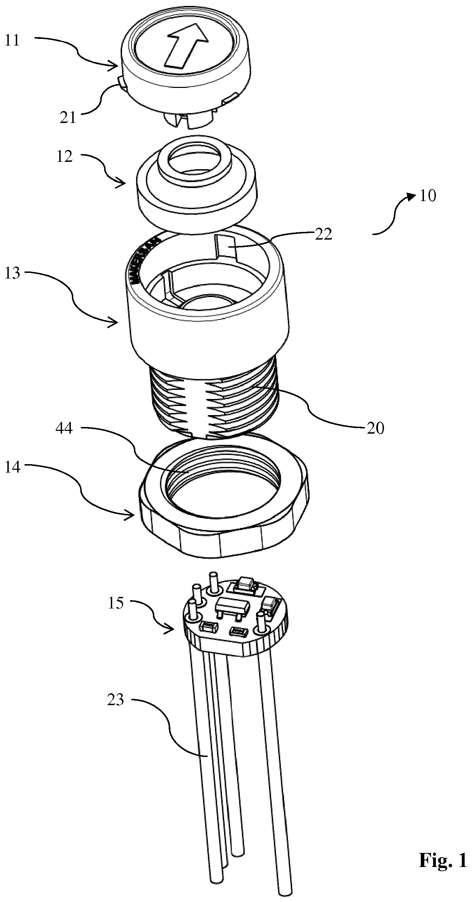

During the first mounting, claws (21) are stretched and fit into the housing inside the body (13). When the user presses on the button (11), said resilient member (12) yields a tactile effect. When the user withdraws his/her hand, however, said resilient member (12) brings the button (11) to its former position. The claws (21) on the button (11) prevent the button (11) from being released from the desired position and being displaced, and also prevent the button (11) from rotating in an undesired manner. Moreover, various figures are processed on the button (11) to guide the user, which can be down arrow and up arrow as in Figure 1.

Switching of the push-button switch (10) described in the preferred embodiment of the invention is provided preferably with Hall Effect. It is also possible for the skilled person in the state of the art to use a different magnetization method other than the hall effect. For example, it is also possible to use reed switch on the printed circuit board. Getting to the root of the invention, an "H" type body (13) is used when it is sectioned, and push-button switch structure with a sealing feature that can be used in different applications is obtained.

Even in case the button (11) and the resilient member (12) remaining in the upper section of the intermediate portion (40a) which allows for forming an intermediate layer lose their function, the system will maintain its sealing. When these parts (resilient member and button) are changed, the switch will still continue to operate in a sealed manner. Referring to Figure 4, in a preferred embodiment of the invention, at least one air vent recess (33) is disposed inside the inner wall of said body (13). Comfortable operation of the resilient member (12) is provided with the air vent recesses (33) extending inside the body inner wall in a manner to remain preferably between the inner housing and the recess (22). In a preferred embodiment of the invention, it is obvious to the skilled person in the state of the art that this air vent recess (33) formed in "L" shape can also be formed in different shapes.

In a preferred embodiment of the invention, the present body (13) of said push-button switch (10) is made of a transparent material providing light transmission in order to provide both lighting at night and different colors of function light to the user. Light source for lighting at night and a different color of function light source are disposed on said printed circuit board (15). To provide the user to detect the light sources on the printed circuit board (15), use of a body (13) made of a translucent material is preferred. Moreover, the components on the printed circuit board can be placed in a single-sided manner or they can also be used in a double-sided manner in order to use both sides of the printed circuit board.

Referring to Figure 1, at least one portion of the outer wall of said body (13) is fitted with helically extending threads, and comprises a threaded portion (20) which will allow for the passage of a connection ring (14) having opposing protrusions. Inner wall of the connection ring (14) comprises connection ring threaded portion (44) on the outer wall thereof in a manner to correspond to these threads. Connection ring (14) corresponds to the opposing threads and moves on the body (13) and thus, connection to a suitable panel or control portion is provided.

In a preferred embodiment of the invention, a classical spring use is eliminated. Instead, a cylindrically formed resilient member (12) is used. As will be see in Figure 1, the resilient member (12) which is configured such that an upper wall of a cylindrical body is narrowed and hollowed closes the portion it is positioned according to the different layer structures formed inside the body (13). When the user pushed the button (11), upper portion of the resilient member contacting the button (11) is stretched.

## Claims

1. A push-button switch (10) comprising:
a body (13);
a button (11) at least partially placed into the body (13);
a magnetic member (30) attached with the button (11);
a resilient member (12) placed between the button (11) and the body (13); and a printed circuit board (15) positioned in the body (13) **wherein** the body (13) comprises a cylindrically formed inner housing (32) and an intermediate portion (40) integrated with an inner portion of the body (13) forming a closed intermediate layer inside the body (13) closing the bottom of said cylindrically formed inner housing (32) such that a longitudinal cross section of the push-button switch is in a H type so as to prevent leakage to the printed circuit board (15) therein,
wherein the printed circuit board (15) is positioned under the intermediate portion (40) and the magnetic member (30) is positioned above the intermediate portion (40),
**characterized in that** said switch (10) further comprises at least one recess (22) on said body (13) and at least one claw (21) on the button (11) in a manner to correspond to this at least one recess (22).

2. The push-button switch (10) as in Claim 1, **characterized in that** said switch (10) further comprises at least one air vent recess (33) on the body in an inner wall of which said resilient member (12) is positioned in a manner to allow for movement of the resilient member (12) inside the body (13).

3. The push-button switch (10) as in Claim 1, **characterized in that** said body (13) is made of at least partially transparent material in a manner to provide light transmission.

4. The push-button switch (10) as in Claim 1, **characterized in that** at least one LED light source is placed on the printed circuit board (15).

5. The push-button switch (10) as in Claim 1, **characterized in that** said magnetic member (30) is embedded inside the button (11).

6. The push-button switch (10) as in Claim 1, **characterized in that** the 2. outer wall of said body (13) comprises at least a partially threaded portion (20) in order to provide connection thereof.

7. The push-button switch (10) as in Claim 1, **characterized in that** said magnetic member (30) can be selected from natural magnet, NdFeB, Sm-Co, Sm-Fe, samarium, cobalt, neodymium.

## Patentansprüche

1. Druckknopfschalter (10), der aufweist:
einen Körper (13);
einen Knopf (11), der zumindest teilweise im Körper (13) angeordnet ist;
ein magnetisches Element (30), das am Knopf (11) befestigt ist;
ein elastisches Element (12), das zwischen dem Knopf (11) und dem Körper (13) angeordnet ist; und
eine im Körper (13) positionierte Leiterplatte (15);
wobei der Körper (13) ein zylindrisch geformtes inneres Gehäuse (32) und einen Zwischenteil (40) aufweist, der in einen inneren Teil des Körpers (13) integriert ist, der eine geschlossene Zwischenlage innerhalb des Körpers (13) formt, die den Boden des zylindrisch geformten inneren Gehäuses (32) verschließt, so dass ein Längsquerschnitt des Druckknopfschalters vom H-Typ ist, um eine Leckage auf die Leiterplatte (15) darin zu verhindern,
wobei die Leiterplatte (15) unter dem Zwischenteil (40) positioniert ist, und das magnetische Element (30) über dem Zwischenteil (40) positioniert ist,
**dadurch gekennzeichnet, dass** der Schalter (10) weiter mindestens eine Aussparung (22) auf dem Körper (13) und mindestens eine derartige Klaue (21) auf dem Knopf (11) aufweist, dass sie dieser mindestens einen Aussparung (22) entspricht.

2. Druckknopfschalter (10) nach Anspruch 1, **dadurch gekennzeichnet, dass** der Schalter (10) weiter mindestens eine Entlüftungsaussparung (33) auf dem Körper aufweist, in einer Innenwand von welcher das elastische Element (12) so positioniert ist, dass die Bewegung des elastischen Elements (12) innerhalb des Körpers (13) ermöglicht wird.

3. Druckknopfschalter (10) nach Anspruch 1, **dadurch gekennzeichnet, dass** der Körper (13) aus zumindest teilweise transparentem Werkstoff besteht, um eine Lichtdurchlässigkeit zu liefern.

4. Druckknopfschalter (10) nach Anspruch 1, **dadurch gekennzeichnet, dass** mindestens eine LED-Lichtquelle auf der Leiterplatte (15) angeordnet ist.

5. Druckknopfschalter (10) nach Anspruch 1, **dadurch gekennzeichnet, dass** das magnetische Element (30) in den Knopf (11) eingebettet ist.

6. Druckknopfschalter (10) nach Anspruch 1, **dadurch gekennzeichnet, dass** die Außenwand des Körpers (13) mindestens einen teilweise mit Gewinde versehenen Teil (20) aufweist, um für dessen Verbindung zu sorgen.

7. Druckknopfschalter (10) nach Anspruch 1, **dadurch gekennzeichnet, dass** das magnetische Element (30) aus einem natürlichen Magneten, NdFeB, Sm-Co, Sm-Fe, Samarium, Kobalt, Neodym ausgewählt werden kann.

## Revendications

1. - Interrupteur à bouton-poussoir (10) comprenant :
un corps (13) ;
un bouton (11) placé au moins partiellement dans le corps (13) ;
un élément magnétique (30) fixé au bouton (11) ;
un élément élastique (12) placé entre le bouton (11) et le corps (13) ; et
une carte de circuits imprimés (15) positionnée dans le corps (13), **dans lequel** le corps (13) comprend un boîtier interne de forme cylindrique (32) et une partie intermédiaire (40) intégrée à une partie interne du corps (13) formant une couche intermédiaire fermée à l'intérieur du corps (13) fermant le fond dudit boîtier interne de forme cylindrique (32) de telle sorte qu'une section transversale longitudinale de l'interrupteur à bouton-poussoir est de type H de façon à empêcher une fuite vers la carte de circuits imprimés (15) à l'intérieur de celui-ci,
dans lequel la carte de circuits imprimés (15) est positionnée sous la partie intermédiaire (40) et l'élément magnétique (30) est positionné au-dessus de la partie intermédiaire (40),
**caractérisé par le fait que** ledit interrupteur (10) comprend en outre au moins un renfoncement (22) sur ledit corps (13) et au moins une griffe (21) sur le bouton (11) de manière à correspondre à cet au moins un renfoncement (22).

2. - Interrupteur à bouton-poussoir (10) selon la revendication 1, **caractérisé par le fait que** ledit interrupteur (10) comprend en outre au moins un renfoncement d'évent (33) sur le corps dans une paroi interne duquel ledit élément élastique (12) est positionné de manière à permettre un mouvement de l'élément élastique (12) à l'intérieur du corps (13).

3. - Interrupteur à bouton-poussoir (10) selon la revendication 1, **caractérisé par le fait que** ledit corps (13) est réalisé en un matériau au moins partiellement transparent de manière à permettre une transmission de lumière.

4. - Interrupteur à bouton-poussoir (10) selon la revendication 1, **caractérisé par le fait qu'**au moins une source de lumière à diode électroluminescente, DEL, est placée sur la carte de circuits imprimés (15).

5. - Interrupteur à bouton-poussoir (10) selon la revendication 1, **caractérisé par le fait que** ledit élément magnétique (30) est intégré à l'intérieur du bouton (11).

6. - Interrupteur à bouton-poussoir (10) selon la revendication 1, **caractérisé par le fait que** la paroi externe dudit corps (13) comprend au moins une partie partiellement filetée (20) de façon à permettre un raccordement de celle-ci.

7. - Interrupteur à bouton-poussoir (10) selon la revendication 1, **caractérisé par le fait que** ledit élément magnétique (30) peut être choisi parmi un aimant naturel, NdFeB, Sm-Co, Sm-Fe, samarium, cobalt, néodyme.
